# EUROPEAN PATENT APPLICATION

(11) **EP 2 612 745 A1**
(43) Date of publication of application: **10.07.2013**
(21) Application number: 11821285.1
(22) Date of filing: 25.08.2011
(51) Int. Cl.: B29C 65/18, B29C 63/02

(54) **LAMINATING METHOD**

(30) Priority: 03.09.2010 JP 2010198072
(71) Applicant: Fuji Electric Co. Ltd., Kanagawa 210-9530 (JP)
(72) Inventor: YOSHIDA, Takashi, Kawasaki-shi Kanagawa 210-9530 (JP)
(74) Representative: MERH-IP Matias Erny Reichl Hoffmann
(86) International application number: PCT/JP2011/004733
(87) International publication number: WO 2012/029262

(57) **Abstract**

A solar battery cell serving as a member to be protected is sandwiched between protective films for lamination and disposed in a press-type laminating device (100). The protective films are then heated, and when the temperature of the protective films becomes a first temperature which is equal to or higher than the softening point of the protective films, pressing of the protective films and the solar battery cell is started. Then the protective films are held at a second temperature (target temperature) that is higher than the first temperature, in a state in which the protective films and the member to be protected are pressed.

## Description

### TECHNICAL FIELD

The present invention relates to a laminate processing method for laminate-processing a member to be protected.

### BACKGROUND ART

Laminate processing is one of the methods for protecting a member to be protected. For example, laminate processing has been used as a method for protecting solar battery cells formed by using a flexible substrate (see, for example, Patent Documents 1 to 6).

Patent Document 1: Japanese Patent Application Publication No. 2004-311571
Patent Document 2: Japanese Patent Application Publication No. 2008-296583
Patent Document 3: Japanese Patent Application Publication No. 2010-12786
Patent Document 4: Japanese Patent Application Publication No. 2010-23485
Patent Document 5: Japanese Patent Application Publication No. 2010-149506
Patent Document 6: Japanese Patent Application Publication No. S63-21879

In order to decrease the production cost of the members to be laminate-processed, it is necessary to increase the throughput of laminate processing of the members.

### DISCLOSURE OF THE INVENTION

With the foregoing in view, it is an objective of the present invention to provide a laminate processing method having increased throughput.

The laminate processing method in accordance with the present invention has the following steps. A member to be protected is sandwiched between protective films for lamination and disposed in a press-type laminating device. The protective films are then heated, and when the temperature of the protective films becomes a first temperature which is equal to or higher than the softening point of the protective films, pressing of the protective films and the member to be protected is started. Then, in a state in which the protective films and the member to be protected are pressed, the protective films are held at a second temperature that is higher than the first temperature.
The first temperature may be equal to or higher than the softening temperature, but is preferably equal to or higher than the melting point.

In accordance with the present invention, the throughput of laminate processing can be increased.

### BRIEF DESCRIPTION OF THE DRAWINGS

The above and other objectives, features and advantages will be made more apparent by the following description of the preferred embodiments, with reference to the accompanying drawings.

FIG. 1 is a timing chart illustrating schematically the laminate processing method according to the first embodiment.
FIG. 2 is a cross-sectional view illustrating the configuration of a laminating device used in the laminate processing method of the first embodiment.
FIG. 3 is a cross-sectional view illustrating the configuration of a solar battery module.
FIG. 4 is a flowchart illustrating a method for laminating the solar battery cell shown in FIG. 3 with protective films by using the laminating device shown in FIG. 2.
FIG. 5 is a flowchart illustrating a variation example of FIG. 4.
FIG. 6 is a flowchart illustrating a variation example of FIG. 4.
FIG. 7 is a cross-sectional view illustrating the laminate processing method of the second embodiment.
FIG. 8 illustrates the configuration of a laminate processing device used in the laminate processing method of the third embodiment.
FIG. 9 is a flowchart for explaining a method for performing laminate processing by using the laminate processing device shown in FIG. 8.
FIG. 10 illustrates the configuration of the laminate processing device according to the fourth embodiment.

### BEST MODE FOR CARRYING OUT THE INVENTION

The embodiment of the present invention will be explained below with reference to the appended drawings. In all the drawings, like constituted elements are assigned with like reference numerals and the explanation thereof is herein omitted.

### First Embodiment

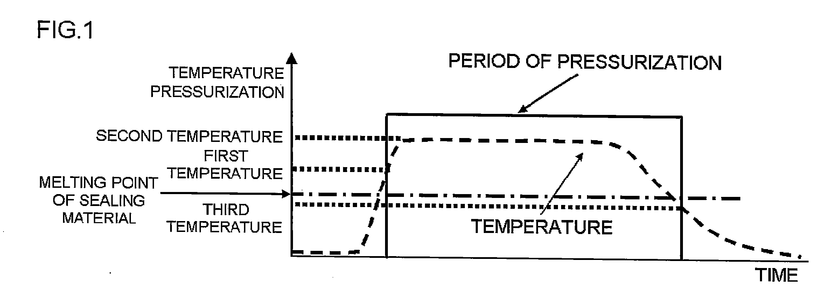

FIG. 1 is a timing chart illustrating schematically the laminate processing method according to the first embodiment. The laminate processing method according to this embodiment has the following steps. A solar battery cell, which is the member to be protected, is sandwiched between protective films for lamination and disposed in a press-type laminating device 100. The protective films are then heated, and when the temperature of the protective films becomes a first temperature which is equal to or higher than the softening point of the protective films, pressing of the protective films and the solar battery cell is started. The first temperature may be equal to or higher than the softening temperature, but is preferably equal to or higher than the melting point. Then, in a state in which the protective films and the member to be protected are pressed, the protective films are held at a second temperature (target temperature) that is higher than the first temperature.

In the usual laminate processing, pressing is started after the protective films reach the second temperature (target temperature). By contrast, in the present embodiment, the pressing is started after the protective films reach the first temperature which is lower than the second temperature. Thus, since the first half of the pressing processing overlaps the second half of the temperature rise step, the time necessary for the laminate processing is shortened by the overlapping time period. Therefore, in the present embodiment, the throughput of laminate processing can be increased.

Meanwhile, where the press processing is started when the temperature of the protective films is less than the softening temperature of the protective film, since the protective films are not softened, when protrusions and depressions are present at the surface of the solar battery cell, a pressing-induced load is concentrated at the protrusions of the solar battery cell and the solar battery cell can be damaged or displaced. By contrast in the present embodiment, the pressing of the protective films and the solar battery cell is started when the temperature of the protective films becomes the first temperature which is equal to or higher than the softening temperature of the protective films. Therefore, the solar battery cells can be prevented from being damaged or displaced.

Where the pressing of the protective films is continued till the protective films are cooled to the normal temperature, the throughput of laminate processing is decreased. Meanwhile, where the pressing of the protective films is ended before the temperature of the protective films becomes lower than the softening point, since the protective films and the solar battery cell have different linear thermal coefficients, wrinkles can occur in the protective films when the protective films solidify. By contrast, in the present embodiment, cooling of the protective films is started while the protective films are still pressed after holding the protective films at the second temperature. The pressing is ended when the protective films reach a third temperature which is higher than the normal temperature and equal to or lower than the softening point of the protective films. As a result, the throughput of laminate processing can be increased, while inhibiting the occurrence of wrinkles in the protective films. The first embodiment is explained below in greater detail.

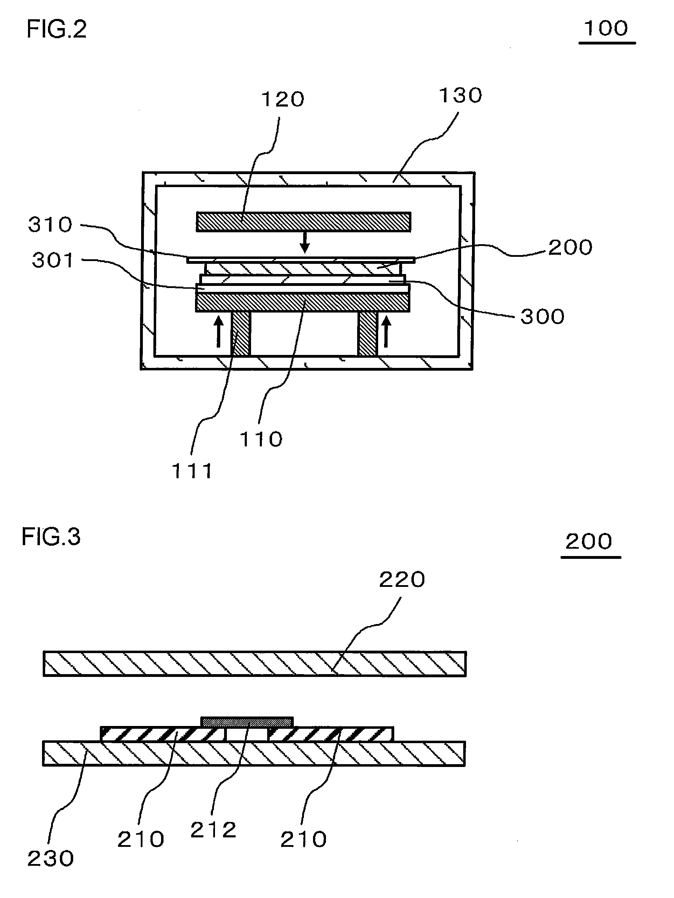

FIG. 2 is a cross-sectional view illustrating the configuration of a laminating device 100 used in the laminate processing method of the first embodiment. In this laminating device, heating plates 110, 120 and a pressing unit 111 are provided in a processing tank 130. A solar battery module 200 prior to lamination, which is an example of the member to be protected, is disposed at the lower heating plate 110. The solar battery module 200 has a configuration in which a solar battery cell is sandwiched between protective films for laminate processing. The solar battery cell is formed using a flexible substrate. The laminate processing of the solar battery cell is performed by the pressing unit 111 by bringing the heating plates 110, 120 close to each other, thereby squeezing the solar battery module 200 located on the heating plate 110. The heating plates 110, 120 have a cooling unit (for example, a water cooling pipe) in addition to a heater. The heater and cooling unit of the heating plates 110, 120 are controlled by a control unit (not shown in the figure).

In this configuration, the solar battery module 200 is placed on a movable laminate frame 301 and placed together with the laminate frame 301 on the heating plate 110.

In the example shown in the figure, the solar battery module 200 is disposed so that the light receiving surface thereof faces the laminate frame 301. A depression-protrusion forming member 300 is disposed between the solar battery module 200 and the laminate frame 301. The depression-protrusion forming member 300 is, for example, a metal mesh and has depressions and protrusions on the surface facing the solar battery module 200. The depression-protrusion forming member 300 forms depressions and protrusions of the surface of the protective film positioned on the light receiving surface side of the solar battery module 200 during laminate processing. As a result of disposing the depression-protrusion forming member 300, the protective films of the solar battery module 200 are preventing from sticking to the heating plate 110.

A parting sheet 310 is disposed between the rear surface side (upper side in the figure) of the solar battery module 200 and the heating plate 120. Depressions and protrusions similar to those of the depression-protrusion forming member 300 are formed on the surface OF the parting sheet 310. As a result of disposing the parting sheet 310, the protective films of the solar battery module 200 are prevented from sticking to the heating plate 120.

An evacuation port (not shown in the figure) is provided in the processing tank 130, and the interior of the processing tank 130 can be evacuated therethrough.

FIG. 3 is a cross-sectional view illustrating the configuration of the solar battery module 200. As shown in the figure, the solar battery module 200 is formed by sandwiching a plurality of solar battery cells 210 connected by a wiring 212 between the protective films 220 and 230 for lamination. The protective film 220 covers the light receiving surface of the solar battery cells 210, and the protective film 230 covers the rear surface of the solar battery cells 210. The protective films 220, 230 have a linear expansion coefficient different from that of the solar battery cells 210. In the example shown in FIG. 2, the wiring 212 is provided at the light receiving surface of the solar battery cells 210, but the wiring 212 may be also provided on the rear surface of the solar battery cells 210.

As shown in the figure, since the solar battery module 200 is provided with the wiring 212, depressions and protrusions appear in the configuration obtained by sandwiching between the protective films 220, 230. Therefore, when the pressing is performed in the laminate processing, a load is easily concentrated in the regions of the solar battery cells 210 where the wiring 212 is provided. However, as described hereinabove, in the present embodiment, the pressing of the protective films 220, 230 and the solar battery cells 210 is started when the temperature of the protective films 220, 230 becomes the first temperature which is equal to or higher than the softening point of the protective films 220, 230. Therefore, the solar battery cells 210 are prevented from damage during the laminate processing.

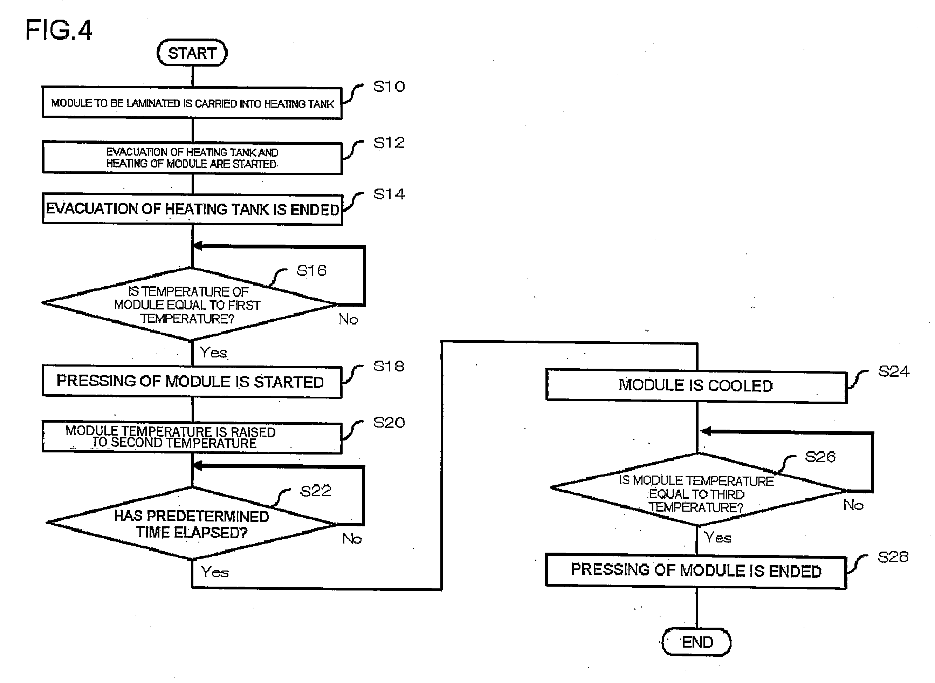

FIG. 4 is a flowchart illustrating a method for laminating the solar battery cell 210 shown in FIG. 3 with the protective films 220, 230 by using the laminating device 100 shown in FIG. 2. First, the solar battery module 200 which is not yet laminated is placed on the laminate frame 301. Then, the laminate frame 301 and the solar battery module 200 are carried into the processing tank 130 of the laminating device 100 and placed on the heating plate 110 (step S10).

The evacuation inside the processing tank 130 is then started and the heating of the heating plates 110, 120 is also started, thereby starting the heating of the solar battery module 200 (step S12). The evacuation of the processing tank 130 ends before the temperature of the solar battery module 200 reaches the first temperature, that is, before the pressing of the solar battery module is started (S14). The solar battery cells 210 are thus prevented from being laminated with the protective films 220, 230 in a state in which air is enclosed in the laminate.

Where the temperature of the solar battery module 200 then reaches the first temperature (step S16: Yes), the pressing unit 111 is driven and the pressing of the solar battery module 200 is started by using the heating plates 110, 120 (step S18). Since the heating of the heating plates 110, 120 is thereafter continued, the temperature of the solar battery module 200 also continues rising. Where the temperature of the solar battery module 200 then reaches the second temperature (target temperature), the output of the heating plates 110, 120 is controlled so that the solar battery module 200 is maintained at the second temperature (step S20).

Where the solar battery module 200 is maintained for a predetermined time at the second temperature (step S22: Yes), the protective films 220, 230 stick to each other. The cooling of the heating plates 110, 120 is then started (step S24). Where the cooling is performed till the temperature of the solar battery module 200 reaches the third temperature (step S26: Yes), the pressing of the solar battery module 200 by the heating plates 110, 120 is ended (step S28). The interior of the processing tank 130 is then returned to the atmospheric pressure and the solar battery module 200 subjected to the laminate processing is taken out from the processing tank 130.

According to the above-described embodiment, the throughput of laminate processing can be increased. Further, the decrease in the yield of the solar battery module 200 can be prevented.

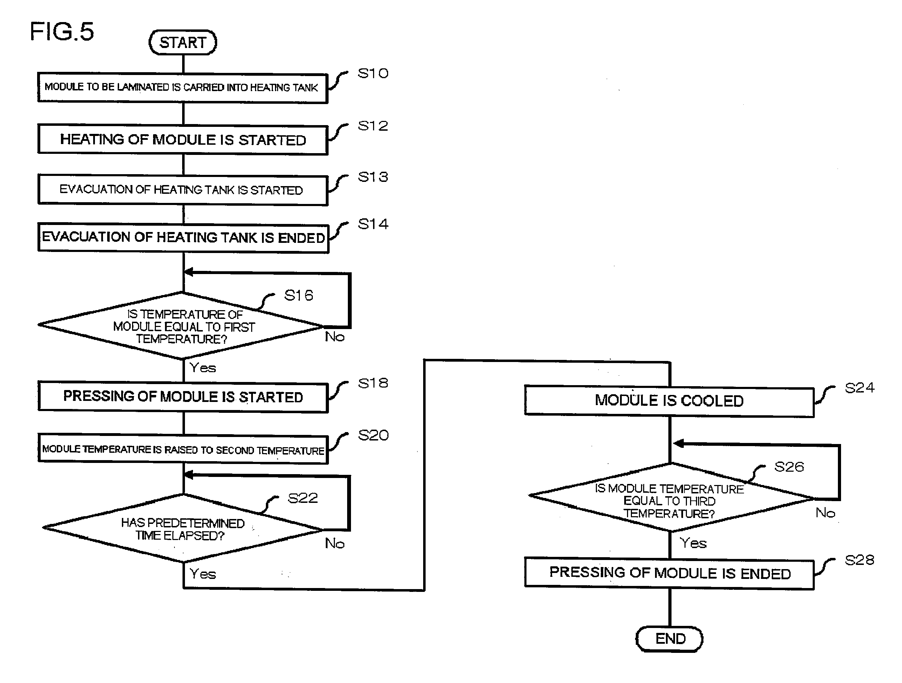

In the above-described embodiment, when the temperature rise rate of the solar battery module 200 is lower than the evacuation rate of the processing tank 130, the evacuation of the heating tank may be started (step S13) after the heating of the heating plates 110, 120 has been started (step S12), as shown in the flowchart in FIG. 5.

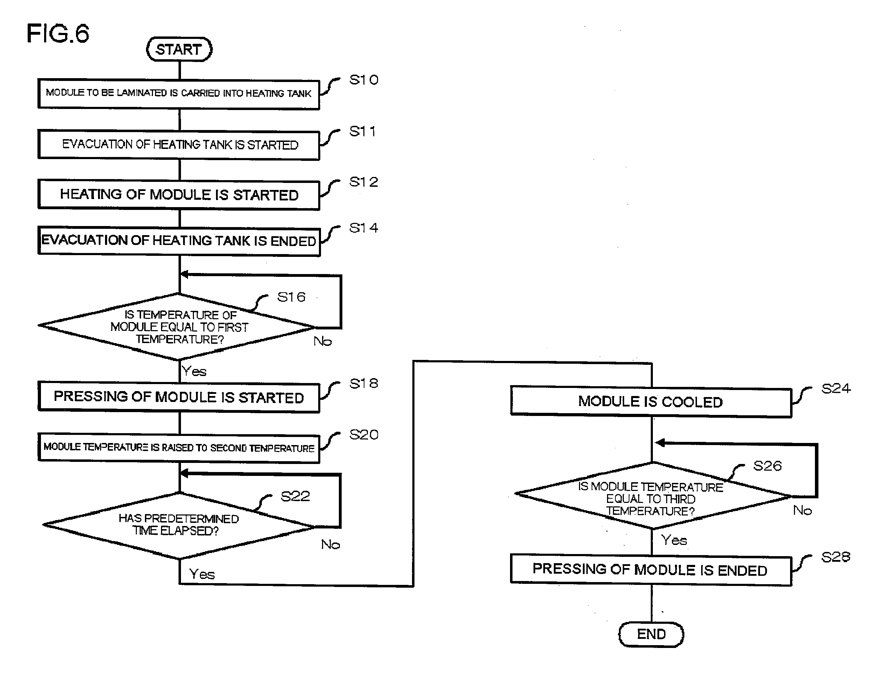

Conversely, when the temperature rise rate of the solar battery module 200 is higher than the evacuation rate of the processing tank 130, the heating of the heating plates 110, 120 may be started (step S12) after the evacuation of the heating tank has been started (step S11), as shown in the flowchart in FIG. 6.

### Second Embodiment

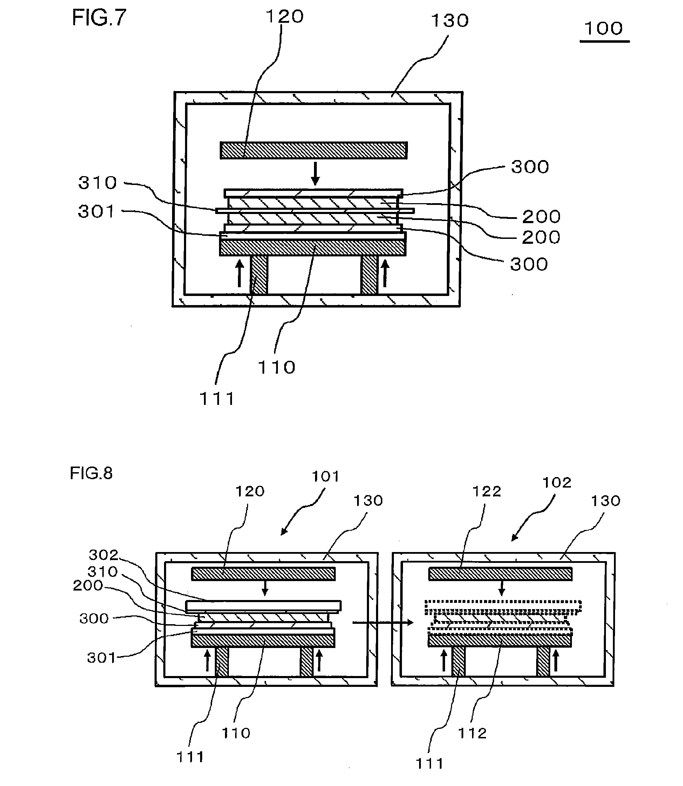

FIG. 7 is a cross-sectional view illustrating the laminate processing method of the second embodiment. The laminate processing method of the present embodiment is similar to the laminate processing method of the first embodiment, except that a plurality of solar battery modules 200 is subjected to laminate processing at the same time.

More specifically, the depression-protrusion forming member 300 is disposed on the laminate frame 301. The solar battery module 200 is then disposed on the depression-protrusion forming member 300 so that the light receiving surface of the solar battery module faces the depression-protrusion forming member 300. Then, the parting sheet 310 and another solar battery module 200 are successively disposed on this solar battery module 200. The latter solar battery module 200 is disposed so that the rear surface thereof faces the partition sheet 310. The depression-protrusion forming member 300 is then disposed on this solar battery module 200.

The laminate processing is then performed by simultaneously heating and pressurizing the plurality of the solar battery modules 200 with the heating plates 110, 120.

FIG. 7 illustrates an example in which two solar battery modules 200 are stacked. In the depression-protrusion forming member 300 positioned in the lowermost layer, the depressions and protrusions are formed at both surfaces or at the solar battery 200 side, the solar battery module 200, the parting sheet 310 having depressions and protrusions formed on both surfaces thereof, and the solar battery module 200 are arranged to form a stack, and the depression-protrusion forming member 300 is placed as the uppermost layer. In this case, the solar battery modules 200 are so disposed that the light receiving surfaces thereof face the depression-protrusion forming member 300 and the rear surfaces face the parting sheets 310, but such a configuration is not limiting, and the two solar battery modules 200 may be so disposed that the light receiving surfaces or rear surfaces thereof face each other, with the depression-protrusion forming member 300 being interposed therebetween.

The depression-protrusion forming members 300 or the parting sheets 310 may be arranged between the two solar battery modules 200 and also at both sides, and the two solar batteries 200 may not be particularly disposed so that the light receiving surfaces or rear surface thereof face each other, and may be disposed in the same direction. Further, in the configuration shown in FIG. 7, two solar batteries 200 are stacked, but a larger number of solar batteries may be also stacked.

The effect similar to that of the first embodiment can be also obtained in the present embodiment. In addition, since the plurality of the solar battery modules 200 can be formed at the same time, the throughput of the laminate processing can be further increased. Furthermore, since the plurality of the solar battery modules 200 is pressed mechanically using a pressing unit, a sufficient pressure can be applied to each solar battery module 200 even if the number of stacked solar battery modules 200 is large.

### Third Embodiment

FIG. 8 illustrates the configuration of a laminate processing device used in the laminate processing method of the third embodiment. The laminate processing device according to the present embodiment has a heating tank 101 for heating and a cooling tank 102 for cooling. The configurations of the heating tank 101 and cooling tank 102 are similar to the configuration of the laminating device 100 described in the first embodiment. However, the cooling tank 102 has plates 112, 122 instead of the heating plates 110, 120. The plates 112, 122 are not provided with a heating unit such as a heater, but have a cooling unit such as a water cooling pipe.

Further, on the laminate frame 301, a thermally insulating member 302 is placed on the stack including the depression-protrusion forming member 300, solar battery module 200, and partition sheet 310. The thermally insulating member 302 has a sheet- or panel-like shape and is configured, for example, to have a thermally insulating material sandwiched between resin films or rubber films.

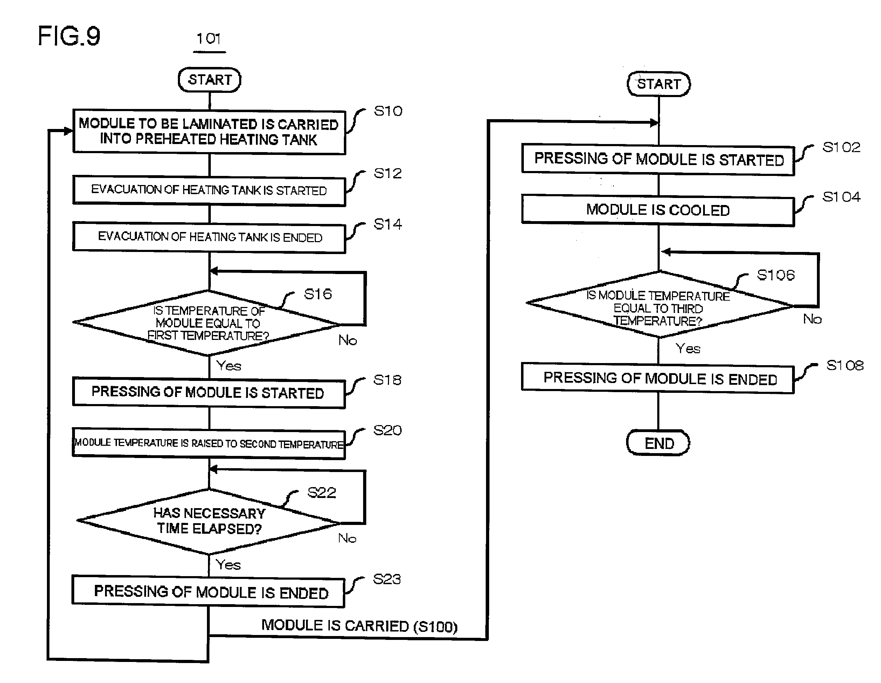

FIG. 9 is a flowchart for explaining a method for performing laminate processing by using the laminate processing device shown in FIG. 8. First, the processing of steps S10 to S22 is performed in the heating tank 101. The details of the processing of steps S10 to S22 is similar to that of the first or second embodiment.

Where the solar cell module 200 is maintained for the predetermined time at the second temperature (step S22: Yes), the protective films 220, 230 stick to each other. The pressing unit 111 then ends the pressing of the solar cell module 200 (step S23).

Then, in a state in which the depression-protrusion forming member 300, solar cell module 200, parting sheet 310, and thermally insulating member 302 are placed on the laminate film 301, the laminate film 301 is taken out of the heating tank 101 and transported to the cooling tank 102 (step S100). Since the thermally insulating member 302 has been placed on the solar cell module 200 in step S100, the solar cell module 200 is prevented from being cooled to a temperature lower than the softening point of the protective films 220, 230 in the transportation process.

The next laminate film 301 is then carried into the heating tank 101 in a state in which the depression-protrusion forming member 300, solar cell module 200, parting sheet 310, and thermally insulating member 302 are placed thereon (step S10), and the next solar cell module 200 is subjected to the laminate processing.

In parallel with the laminate processing, the depression-protrusion forming member 300, solar cell module 200, parting sheet 310, and thermally insulating member 302 located on the laminate film 301 and transported into the cooling tank 102 are pressed by the plates 112, 122 (step S102) and cooled by the plates 112, 122 in this state (step S104). Where the temperature of the solar cell module 200 is reduced to the third temperature (step S106: Yes), the pressing of the solar cell module 200 by the heating plates 110, 120 is ended (step S108). The processed solar cell module 200 is then taken out of the cooling tank 102.

The operation and effects of the present embodiment are explained below. The effect obtained in the present embodiment can be same as in the first or second embodiment. Further, where all of the processing steps are performed in the same tank, the heating plates 110, 120 should be heated and cooled each time the laminate processing is performed. By contrast, in the present embodiment, the heating and pressurization processing necessary for lamination are performed in the heating tank 101, and the subsequent cooling processing is performed in the cooling tank 102. Therefore, the heating plates 110, 120 can be maintained in the heated state. Further, it is not necessary to heat the plates 112, 122 when the cooling of the solar cell module 200 is started, and the cooling rate of the solar cell module 200 can be increased. Therefore, the time necessary for one cycle of laminate processing can be reduced.

Further, since the heating plates 110, 120 can be maintained in the heated state, the energy (for example, electric power) consumed by the heating plates 110, 120 can be reduced.

Further, in the present embodiment, thermal capacity of the depression-protrusion forming member 300 and parting sheet 310 may be increased by increasing the thickness thereof. In this case, the solar cell module 200 can be prevented from being cooled to a temperature below the softening temperature of the protective films 220, 230 when the solar cell module 200 is transported from the heating tank 101 to the cooling tank 102.

### Fourth Embodiment

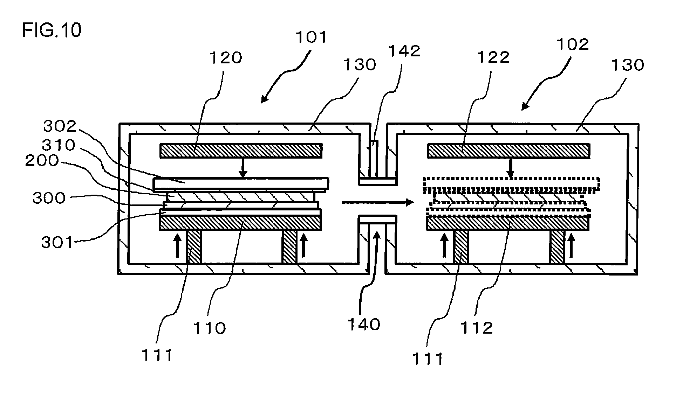

FIG. 10 illustrates the configuration of the laminate processing device according to the fourth embodiment. This laminate processing device is similar to the laminate processing device according to the third embodiment, except that the heating tank 101 and the cooling tank 102 are connected by a connection member 140. The connection member 140 has a shutter 142. The shutter 142 is closed except when the laminate frame 301 is transported from the heating tank 101 into the cooling tank 102 in a state in which the depression-protrusion forming member 300, solar cell module 200, parting sheet 310, and thermally insulating member 302 are placed thereon. A transportation unit, for example, a conveyor (not shown in the figure), for transporting the laminate frame 301 is provided from the heating tank 101 to the cooling 102 through the connection member 140.

A method for performing the laminate processing by using the laminate processing device according to the present embodiment is the same as that of the third embodiment.

The effect similar to that of the third embodiment can be also obtained in the present embodiment. Further, since the heating tank 101 and the cooling tank 102 are connected by the connection member 140, the solar battery module 200 can be easily transported from the heating tank 101 to the cooling tank 102.

The embodiments of the present invention are explained above with reference to the drawings, but those embodiments are merely examples of the present invention and a variety of other configurations can be also used.

This application claims priority to Japanese patent Application No. 2010-198072 filed on September 3, 2010, the entire contents of which are hereby incorporated by reference.

## Claims

1. A laminate processing method comprising the steps of:
sandwiching a member to be protected between protective films for lamination and disposing the sandwiched member in a press-type laminating device;
heating the protective films, and starting pressing of the protective films and the member to be protected when the temperature of the protective films becomes a first temperature which is equal to or higher than a softening point of the protective films; and
holding the protective films at a second temperature that is higher than the first temperature, in a state in which the protective films and the member to be protected are pressed.

2. The laminate processing method according to claim 1, wherein
evacuation inside the laminating device is completed before the protective films and the member to be protected are pressed.

3. The laminate processing method according to claim 1 or 2, wherein
cooling of the protective films is started after the protective films are held at the second temperature, and the pressing is ended when the protective films reach a third temperature which is higher than a normal temperature and equal to or lower than the softening temperature.

4. The laminate processing method according to any one of claims 1 to 3, wherein
the member to be protected is a solar battery cell formed using a flexible substrate.

5. The laminate processing method according to claim 4, wherein
the protective films sandwich a plurality of solar battery cells; and
the plurality of the solar battery cells are connected to each other by using a wiring.

6. The laminate processing method according to claim 4 or 5, wherein
a plurality of the members to be protected which are sandwiched between the protective films are stacked and laminate-processed at the same time.

7. The laminate processing method according to any one of claims 1 to 6, wherein
the laminating device includes a heating tank in which the member to be protected is laminated by the protective films, and a cooling tank in which the laminated member to be protected is cooled,
the heating tank and the cooling tank each has a pressing unit,
the processes preceding and including the step of holding the protective films at the second temperature which is higher than the first temperature are performed in the heating tank, and
the member to be protected is then transported to the cooling tank and cooled in the cooling tank.

8. The laminate processing method according to claim 7, wherein
the laminated member to be protected is transported from the heating tank to the cooling tank in a state in which the protective films are covered with a thermally insulating member.
